# EUROPEAN PATENT APPLICATION

(11) **EP 4 851 650 A1**
(43) Date of publication of application: **09.12.2026**
(21) Application number: 26176757.8
(22) Date of filing: 06.05.2026
(51) Int. Cl.: G01R 31/52, H02H 3/32

(54) **MULTIFUNCTION PRINTED CIRCUIT BOARD ASSEMBLY CURRENT SENSOR SYSTEM**

(30) Priority: 04.06.2025 US 202519228519
(71) Applicant: Schneider Electric USA, Inc., Boston, MA 02108 (US)
(72) Inventor: FISCHELS, Collin Richard, Cedar Rapids, 52404 (US); MELECIO RAMIREZ, Juan Ignacio, Cedar Rapids, 52404 (US)
(74) Representative: Openshaw & Co.

(57) **Abstract**

A multifunction printed circuit board assembly current sensor system (MFPCBACSS) for use in a circuit breaker includes a CT integrated into a PCBA. The CT has a closed CT core and PCBA conductors arranged on a PCBA substrate to define a plurality of non-overlapping sense windings around the CT core. From the signals output from the multiple sense windings, a single CT can be used to detect ground faults, determine ground fault location, determine load configuration, measure current, and/or detect arc faults. Additional windings for push-to-test operations and grounded-neutral detection can also be provided on the same CT core. Certain embodiments include four sense windings around four non-overlapping quadrants of a closed ferromagnetic CT core.

## Description

### FIELD

This disclosure generally pertains to a multifunction printed circuit board assembly, a current transformer, and a circuit breaker.

### BACKGROUND

Circuit breakers are used to protect against electrical hazards. These devices use current sensors to detect fault conditions (e.g., ground faults, grounded neutral events, arc faults, and overcurrent events) and subsequently interrupt current flow to a circuit to protect individuals and equipment. In the design and manufacture of the current sensors for circuit breakers, there are challenges to ensuring accuracy, reliability, and manufacturing consistency. Furthermore, different types of fault conditions typically require different types of current sensors for accurate detection.

### SUMMARY

In one aspect, a multifunction printed circuit board assembly current sensor system (MFPCBACSS) for use in a circuit breaker comprises a printed circuit board assembly (PCBA) comprising a PCBA substrate and a current transformer (CT) in the PCBA substrate. The CT has a plurality of sectors and comprises a CT core and PCBA conductors arranged on the PCBA substrate to define a plurality of non-overlapping sense windings around the CT core. The sense windings include one respective sense winding in each sector of the CT. A plurality of primary conductors extend through the CT core to interact magnetically with the CT core such that current carried by the primary conductors generates magnetic flux in the CT core and the magnetic flux generated in each sector of the CT induces a secondary current in the respective sense winding.

In another aspect, a current transformer (CT) for a circuit breaker has first, second, third, and fourth sectors. The CT comprises a CT core having a first quadrant in the first sector of the CT, a second quadrant in the second sector of the CT, a third quadrant in the third sector of the CT, and a fourth quadrant in the fourth sector of the CT. A first sense winding is around the first quadrant of the CT core, a second sense winding is around the second quadrant of the CT core, a third sense winding is around the third quadrant of the CT core, and a fourth sense winding is around the fourth quadrant of the CT core. The first sense winding, the second sense winding, the third sense winding, and the fourth sense winding are non-overlapping. A first primary conductor extends through the CT core in the first sector of the CT, a second primary conductor extending through the CT core in the second sector of the CT, and a third primary conductor extending through the CT core in the third sector of the CT.

In another aspect, a circuit breaker comprises a current transformer having a plurality of sectors and comprising a single current transformer (CT) core and a plurality of non-overlapping sense windings. Each sense winding is disposed around a respective one of the sectors of the CT core. A plurality of primary conductors extend through the CT core to interact magnetically with the CT core such that current carried by the primary conductors generates magnetic flux in the CT core and the magnetic flux generated in each sector of the CT core induces a secondary current in the respective sense winding. A trip mechanism is configured to be selectively actuated to interrupt current flow through the primary conductors to a circuit. An actuator is configured to selectively actuate the trip mechanism. A ground fault detector is configured to detect a ground fault in the circuit based on the secondary currents induced in the plurality of sense windings and to signal the actuator to actuate the trip mechanism in response to detecting the ground fault. An arc fault detector is configured to detect an arc fault in the circuit based on the secondary currents induced in the plurality of sense windings and to signal the actuator to actuate the trip mechanism in response to detecting the arc fault.

Other aspects will be in part apparent and in part pointed out hereinafter.

### BRIEF DESCRIPTION OF THE DRAWINGS

The patent or application file contains at least one drawing executed in color. Copies of this patent or patent application publication with color drawing(s) will be provided by the Office upon request and payment of the necessary fee.
FIG. 1 is a schematic block diagram showing elements of a multifunction printed circuit board assembly (PCBA) current sensor system (MFPCBACSS) in accordance with the present disclosure;
FIG. 2 is a perspective of the MFPCBACSS;
FIG. 3 is a cross section of the MFPCBACSS;
FIG. 4 is a perspective of a core and primary conductors of the MFPCBACSS;
FIG. 5 is a perspective of a portion of a PCBA substrate of the MFPCBACSS;
FIG. 6 is another perspective of the portion of the PCBA substrate from FIG. 5;
FIG. 7 is a cross section of the PCBA differential sensor system;
FIG. 7A is a schematic cross section of an example PCBA lay-up suitable for the PCBA differential sensor system;
FIG. 8 is a plan view of the core, the primary conductors, and windings of the MFPCBACSS;
FIG. 9A is a perspective of a test winding of the MFPCBACSS;
FIG. 9B is a plan view of the test winding;
FIG. 10A is a perspective view of a grounded neutral (GN) winding of the MFPCBACSS;
FIG. 10B is a plan view of the GN winding;
FIG. 11A is a perspective view of sense windings of the MFPCBACSS;
FIG. 11B is a plan view of the sense windings;
FIG. 12 is a schematic block diagram showing aspects of a circuit breaker incorporating the MFPCBACSS;
FIG. 13A is a diagram showing the direction of magnetic flux in the CT core of the MFPCBACSS in an L1-N load configuration;
FIG. 13B is a magnetic flux density isovalue contours diagram showing colored vectors on a plan view of the CT core to illustrate simulated magnetic flux density in the L1-N load configuration;
FIG. 13C is a diagram showing the direction of magnetic flux in the CT core of the MFPCBACSS in an L1+GF-N GF configuration;
FIG. 13D is a magnetic flux density isovalue contours diagram showing colored vectors on a plan view of the CT core to illustrate simulated magnetic flux density in the L1+GF-N GF load configuration;
FIG. 14A is a diagram showing the direction of magnetic flux in the CT core of the MFPCBACSS in an L2-N load configuration;
FIG. 14B is a magnetic flux density isovalue contours diagram showing colored vectors on a plan view of the CT core to illustrate simulated magnetic flux density in the L2-N load configuration;
FIG. 14C is a diagram showing the direction of magnetic flux in the CT core of the MFPCBACSS in an L2+GF-N GF configuration;
FIG. 14D is a magnetic flux density isovalue contours diagram showing colored vectors on a plan view of the CT core to illustrate simulated magnetic flux density in the L2+GF-N GF load configuration;
FIG. 15A is a diagram showing the direction of magnetic flux in the CT core of the MFPCBACSS in an L1-L2 load configuration;
FIG. 15B is a magnetic flux density isovalue contours diagram showing colored vectors on a plan view of the CT core to illustrate simulated magnetic flux density in the L1-L2 load configuration;
FIG. 15C is a diagram showing the direction of magnetic flux in the CT core of the MFPCBACSS in an L1+GF-L2 GF configuration;
FIG. 15D is a magnetic flux density isovalue contours diagram showing colored vectors on a plan view of the CT core to illustrate simulated magnetic flux density in the L1+GF-L2 GF load configuration;
FIG. 16A is a diagram showing the direction of magnetic flux in the CT core of the MFPCBACSS in an L1-N-L2 load configuration;
FIG. 16B is a magnetic flux density isovalue contours diagram showing colored vectors on a plan view of the CT core to illustrate simulated magnetic flux density in the L1-N-L2 load configuration;
FIG. 16C is a diagram showing the direction of magnetic flux in the CT core of the MFPCBACSS in an L1+GF-N-L2 GF configuration;
FIG. 16D is a magnetic flux density isovalue contours diagram showing colored vectors on a plan view of the CT core to illustrate simulated magnetic flux density in the L1+GF-N-L2 GF load configuration;
FIG. 17 is another schematic block diagram showing aspects of a circuit breaker incorporating the MFPCBACSS; and
FIG. 18 is a schematic illustration of another embodiment of a PCBA CT in accordance with the present disclosure.

Corresponding parts are given corresponding reference characters throughout the drawings.

### DETAILED DESCRIPTION

Embodiments of the present disclosure are directed to a multifunction printed circuit board assembly (PCBA) current sensor system (MFPCBACSS) for monitoring electrical currents and detecting fault conditions. Certain embodiments of MFPCBACSS in accordance with the present disclosure are suitable for integration into various types of electrical safety devices, including, but not limited to, protective devices (circuit breakers) designed for two-phase and three-phase power systems, as well as for use in tandem multifunction circuit breaker devices. In accordance with various embodiments, the MFPCBACSS comprises a closed core current transformer (CT) with a plurality of discrete, non-overlapping sense windings (secondary conductors) wound on the closed core. High-precision PCBA manufacturing techniques can be used to place each of the sense windings around the closed core, which yields very accurate winding pitch and distribution. Primary conductors are also routed precisely through the closed core to interact magnetically with the core. As will be explained in further detail below, the accurately placed, non-overlapping sense windings allow for sophisticated multifunction evaluation of the currents carried by the primary conductors. In certain embodiments, the MFPCBACSS is able to perform any combination of the following: (i) ground fault (GF) detection, (ii) GF location detection, (iii) current measurement, (iv) load configuration determination, (v) arc fault (AF) detection, (vi) push-to-test (PTT) operations, and/or (vii) grounded neutral (GN) detection.

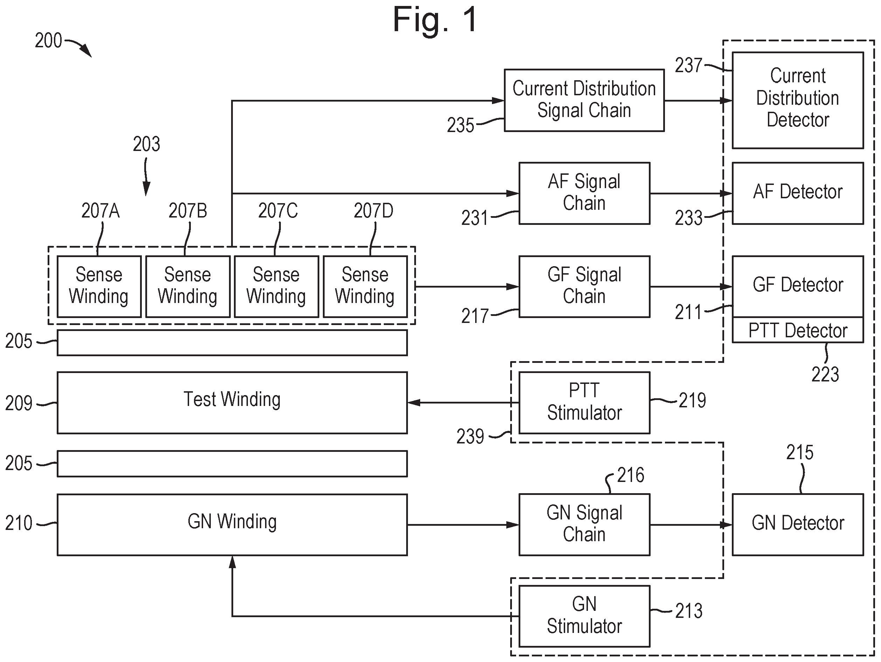

Referring to FIG. 1, an example embodiment of a MFPCBACSS in accordance with the present disclosure is shown schematically at reference number 200. In general, the MFPCBACSS 200 comprises multifunction current transformer (CT) 203 including a closed ferromagnetic CT core 205 (hereinafter, "CT core"). A plurality of sense windings 207A, 207B, 207C, 207D, a test winding 209, and a grounded neutral winding 210 are wound around the same CT core 205. In one embodiment, the MFPCBACSS 200 comprises similar multifunctional capabilities to the multifunction differential sensor system described in US Patent Application Publication No. 2024/0222954, which is assigned to the assignee of the present disclosure. In particular, the functions of the test winding 209 and the GN winding 210 (which are briefly described below) are similar to the corresponding elements in US Patent Application Publication No. 2024/0222954. But as will be explained in further detail below, the sense windings 207A, 207B, 207C, 207D not only facilitate GF detection, but also sophisticated multifunction analysis of GF location, current measurement, load configuration, and/or AF detection. Thus, the MFPCBACSS 200 is broadly configured to provide comprehensive fault detection by integrating multiple functions in a single current transformer 203 on a PCBA.

In one aspect, the sense windings 207A, 207B, 207C, 207D are configured for detecting GF conditions. In the illustrated embodiment, the sense windings 207A, 207B, 207C, 207D are connected to a GF signal chain 217 that processes signals from the sense windings and feeds them into a GF detector 211. The GF detector 211 is responsible for identifying line-to-ground fault conditions. The GF detector 211 also incorporates PTT detection functionality, as illustrated by the PTT detector 223. The sense windings 207A, 207B, 207C, 207D are also connected to an (optional) AF signal chain 231 that processes signals from the sense windings and feeds them to an AF detector 233. Still furthermore the sense windings 207A, 207B, 207C, 207D are connected to a current distribution signal chain 235 that processes signals from the sense windings and feeds them to a current distribution detector 237. The functions of the signal chains 217, 231, 235 and detectors 211, 233, 237 will be described in further detail below.

The test winding 209 is connected to a PTT signal stimulator 219. The primary role of the PTT signal stimulator 219 is to, upon activation (e.g., by a manual PTT button or an automated self-test command), output a test signal to the test winding 209. This test signal simulates a GF condition by creating a magnetic flux imbalance in the CT core 205. The test signal, which can have identifiable characteristics such as a specific amplitude, frequency, or waveform (e.g., a square wave signal), is electromagnetically coupled from the test winding 209 to the sense windings 207A, 207B, 207C, 207D via their shared magnetic link to the CT core 205. The electromagnetic coupling induces a corresponding signal in the sense windings 207A, 207B, 207C, 207D, mimicking the signal that would be present during a GF condition. This induced signal from the sense windings 207A, 207B, 207C, 207D is subsequently processed by the GF signal chain 217 and detected by the PTT detector 223 (which may be integrated with or distinct from the GF detector 211). The successful detection of this specific test signal by the PTT detector 223 verifies the operational integrity of the components in the GF pathway.

The GN winding 210 is connected to a GN stimulator 213 and a GN detector 215 (via the GN signal chain 216). The GN stimulator 213 provides a signal to the GN winding 210, and the GN detector 215 monitors signals from this winding to determine if a GN fault condition exists. In this configuration, the GN detection pathway is distinct and operates using its own dedicated winding 210, stimulator 213, and detector 215.

The various detectors (e.g., GF detector 211, PTT detector 223, GN detector 215, AF detector 233, and current distribution detector 237) and stimulators (e.g., PTT signal stimulator 219, GN stimulators 213) described herein may be realized through any suitable hardware or software-implemented configuration. For example, in the illustrated embodiment, a microcontroller unit (MCU) 239 executes firmware to perform the signal processing (e.g., analog-to-digital conversion, digital-to-analog conversion), logic operations (some of which will be described below), and waveform generation. The MCU 239 typically interfaces with analog front-end (AFE) circuitry that conducts signal conditioning. This AFE circuitry can include operational amplifiers for signal amplification, comparators for threshold detection, and filters (comprising resistors, capacitors, and inductors) to remove noise and select desired signal components from the sense windings before digitization by the MCU's analog-to-digital converters (ADCs). For stimulus generation, the MCU 239 may utilize digital-to-analog converters (DACs), pulse width modulation (PWM) outputs, or general-purpose input/output (GPIO) pins, potentially in conjunction with driver circuits (such as transistors or dedicated driver ICs) to provide sufficient power to the respective test winding 209 and GN winding 210. In alternative embodiments, some or all of the functionalities of these detectors 211, 215, 223, 233, 237 and stimulators 213, 219 may be implemented using application-specific integrated circuits (ASICs), which can consolidate many of the analog and digital functions into a single integrated circuit, or through discrete logic components and dedicated ICs.

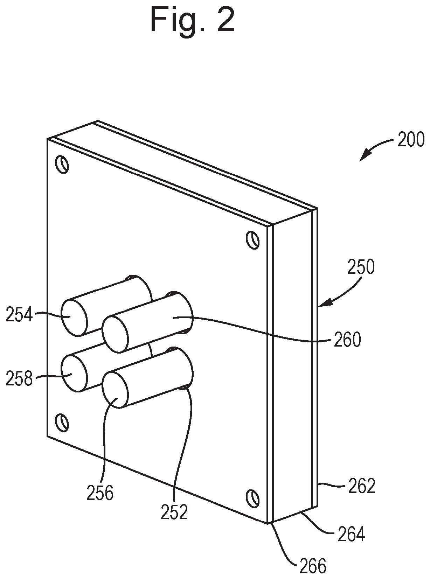

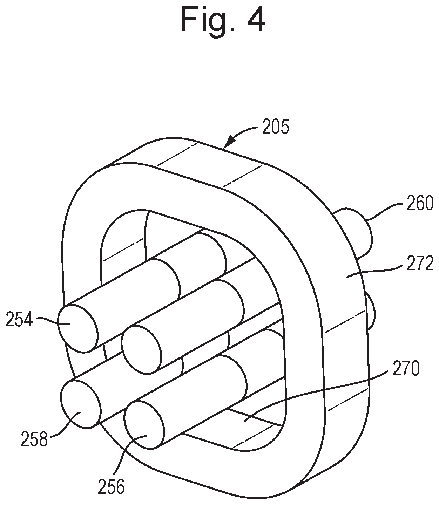

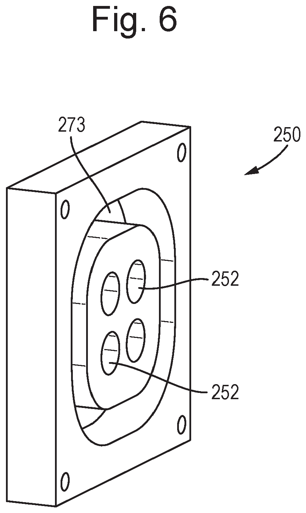

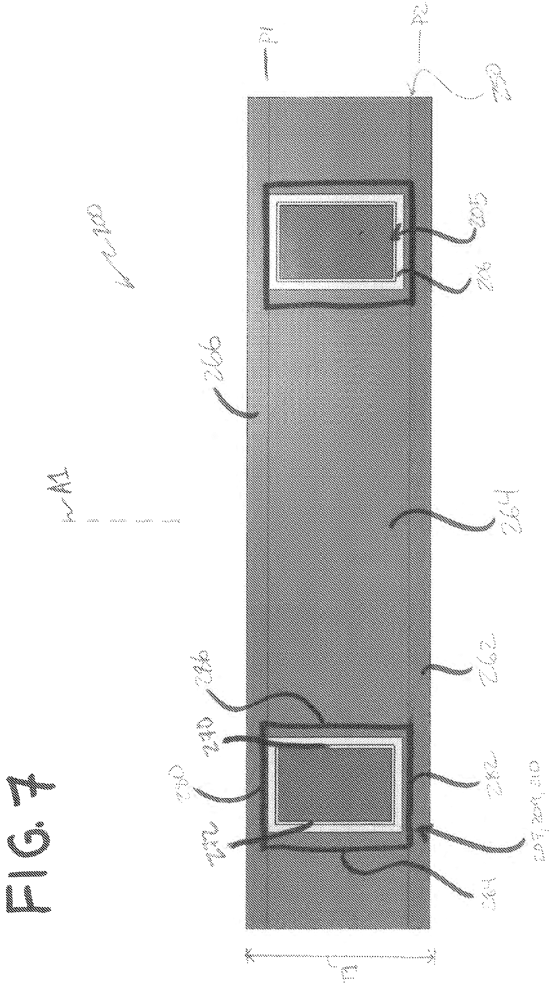

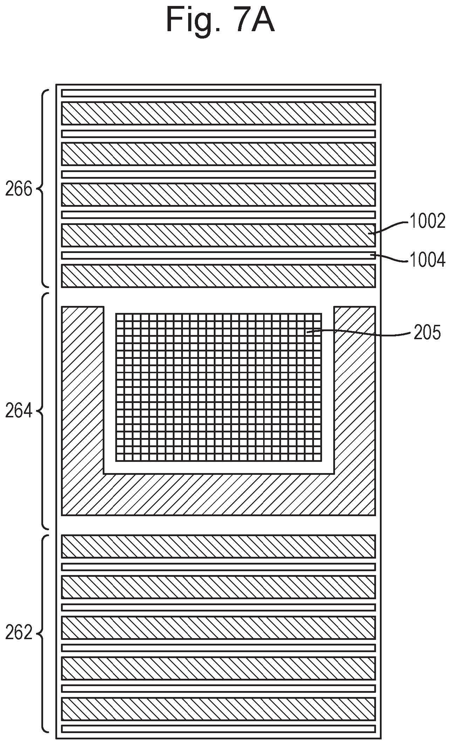

Referring now to FIGS. 2-8, the PCBA structure of the MFPCBACSS 200 will now be described in further detail. The MFPCBACSS 200 broadly comprises a PCBA substrate 250 (e.g., a dielectric substrate) having a thickness T1 (FIG. 7) along a center axis A1 of the CT core 205. Along the thickness T1, the substrate 250 comprises a bottom region 262, a middle region 264, and a top region 266. In one example depicted in FIG. 7A, the middle region 264 is dielectric material, and each of the bottom region 262 and the top region 266 is a stack of five dielectric PCB layers 1002 with alternating conductive PCB layers 1004 in between to form portions of the windings 207, 209, 210. As explained below, the middle region 264 is configured to receive the CT core 205. The bottom region 262 is below the middle region 264, and the top region 266 is above the middle region. The regions 262, 264, 266 may be formed separately and fastened together, or alternatively, two or more substrate regions could comprise one monolithic piece of material. In other words, there are different methods of fabricating a PCBA, and any suitable method can be used without departing from the scope of the disclosure.

The PCBA substrate 250 defines at least one conductor opening 252 extending along the axis A1 through the entire thickness T1 such that a plurality of primary conductors 254, 256, 258, 260 can pass through a central region of the substrate (through the interior of the CT core 205). In the illustrated embodiment, the PCBA substrate 250 defines four spaced apart conductor openings 252, one for each individual primary conductor 254, 256, 258, 260. Each conductor opening 252 is configured to hold a respective one of the conductors 254, 256, 258, 260 at a defined position so that the conductors have a symmetrical arrangement about the center axis A1 of the core 205.

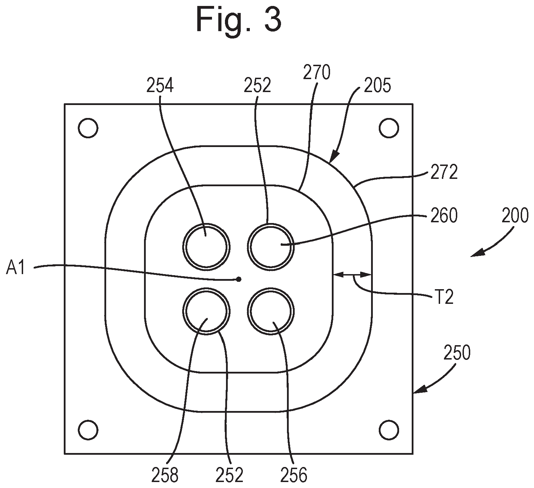

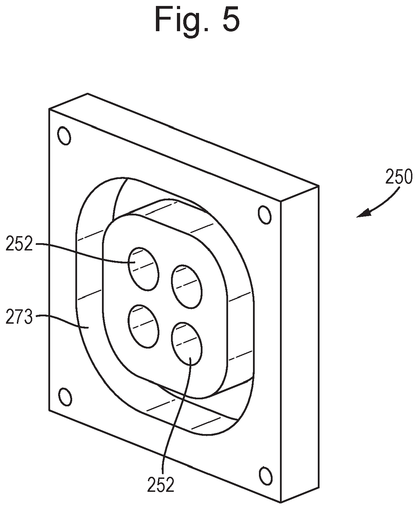

The CT core 205 is embedded in the PCBA substrate 250 to circumscribe the conductor openings 252. The CT core 205 defines a closed loop and has an inner perimeter side 270, an outer perimeter side 272, and a radial thickness T2 (FIG. 3) extending from the inner perimeter side to the outer perimeter side. In the illustrated embodiment, the perimeter shape of the CT core 205 is that of a square with rounded corners. The CT core could also have other perimeter shapes without departing from the scope of the disclosure. Suitably the CT core 205 is formed from nanocrystalline material with high permeability and high saturation flux density for proficient magnetic flux capture. In the illustrated embodiment, the CT core 205 is coated with an epoxy layer 206 (FIG. 7). As shown in FIGS. 5-6, the PCBA substrate 250 (e.g., the middle region 264 of the substrate) comprises a loop-shaped receptacle 273 circumscribing the conductor openings 252 and configured to receive the CT core 205 therein (e.g., the CT core 205 can have a close tolerance fit with the PCBA substrate 250 when received in the loop-shaped receptacle 273).

In the illustrated example, the primary conductor 254 is a first line conductor configured to connect to a first line current conductor (e.g., Line 1 conductor) of a circuit, the primary conductor 256 is a second line conductor configured to connect to a second line current conductor (e.g., Line 2 conductor) of a circuit, the primary conductor 258 is a neutral conductor configured to connect to a neutral conductor of a circuit, and the primary conductor 260 could represent a third line conductor (e.g., Line 3 conductor) in a three-phase system (or the fourth primary conductor 260 could be used as any other type of conductor in a different power configuration). As shown in FIG. 3, the four conductor openings 252 are centered on the four corners of an imaginary square that is centered on the center axis A1 of the CT core 205, and the sides of the imaginary square are parallel to the sides of the CT core 205. Thus, in the illustrated example, the Line 1, Line 2, Line 3 and neutral conductors 254, 256, 258, 260 are arranged at three corners of the imaginary square, with the Line 1 and Line 2 conductors spaced apart along a diagonal of the imaginary square.

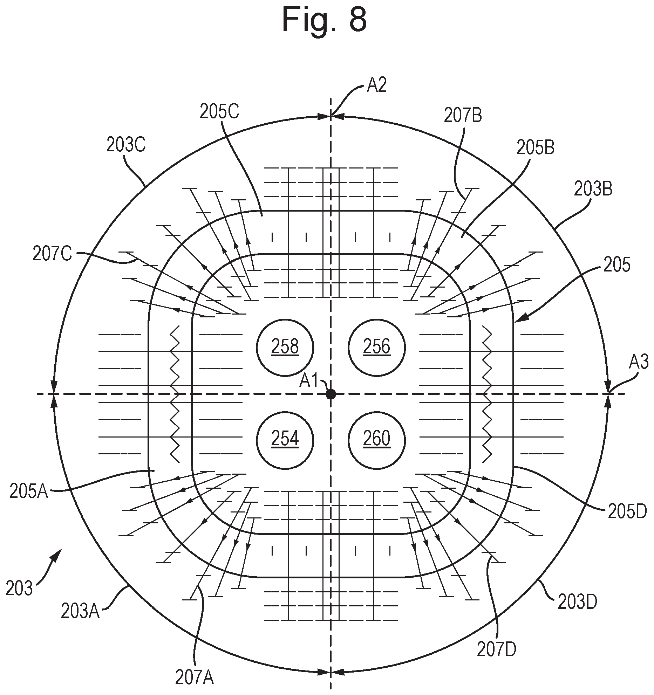

In general, the CT 203 has a plurality of distinct, non-overlapping sectors 203A, 203B, 203C, 203D (FIG. 8). The illustrated CT 203 has first and second radial axes A2, A3 that define four sectors 203A, 203B, 203C, 203D arranged circumferentially about that axis A1. However, it will be understood that the number and arrangement of sectors can vary without departing from the scope of the disclosure. The CT core 205 has a first pair of opposing sides parallel to the first radial axis A2 and a second pair of opposing sides parallel to the second radial axis A3. The radial axes A2, A3 are perpendicular to one another and perpendicular to the center axis A1. The radial axes A2, A3 define first, second, third, and fourth (non-overlapping sectors 203A, 203B, 203C, 203D of the CT 203. In the illustrated embodiment one (and only one) primary conductor 254, 256, 258, 260 is in each sector 203A, 203B, 203C, 203D. In addition, each sector 203A, 203B, 203C, 203D contains a quadrant 205A, 205B, 205C, 205D (or, more broadly, sector) of the CT core 205. The first sense winding 207A is wrapped around a first quadrant 205A of the CT core 205 in the first sector 203A, the second sense winding 207B is wrapped around a second quadrant 205B of the CT core 205 in the second sector 203B, the third sense winding 207C is wrapped around a third quadrant 205C of the CT core 205 in the third sector 203C, and the fourth sense winding 207D is wrapped around a fourth quadrant 205D of the CT core 205 in the fourth sector 203D. The four sense windings 207A, 207B, 207C, 207D do not overlap one another on the core 205. That is, the plurality of sense windings 207A, 207B, 207C, 207D are non-overlapping in the sense that the sense windings are wound around different angular sectors of the core 205 (in relation to the axis A1) and there is no circumferential sector of the core around which two or more of the sense windings are both/all wound. As will be explained in further detail below, localizing each of the four sense windings 207A, 207B, 207C, 207D on a respective quadrant 205A, 205B, 205C, 205D of the CT core 205 (in a respective sector 203A, 203B, 203C, 203D) enhances the current detection capabilities of the CT 203 beyond the capabilities of conventional CTs. Moreover, because of the way the four non-overlapping sense windings 207A, 207B, 207C, 207D are fabricated using PCBA fabrication techniques, it is possible to achieve highly accurate winding positioning so that the MFPCBACSS 200 can fully leverage the enhanced current detection capabilities provided by the segmented sense windings.

The first primary conductor 254 extends through the CT core 205 in the first sector 203A of the CT 203. The second primary conductor 256 extends through the CT core 205 in the second sector 203B of the CT 203. The third primary conductor 258 extends through the CT core 205 in the third sector 203C of the CT. The fourth primary conductor 260 extends through the CT core 205 in the fourth sector 203D of the CT. As can be seen, this positions each primary conductor adjacent to a respective quadrant 205A, 205B, 205C, 205D of the CT core 205 and adjacent to a respective sense winding 207A, 207B, 207C, 207D. Because of this arrangement, each quadrant 205A, 205B, 205C, 205D will have the strongest magnetic interaction with the nearest primary conductor 254, 256, 258, 260, and each sense winding 207A, 207B, 207C, 207D will be most sensitive to the current in the nearest primary conductor 254, 256, 258, 260 (e.g., the primary conductor that is located in the same sector 203A, 203B, 203C, 203D of the CT 203).

Referring to FIG. 7, the way the PCBA conductors are arranged on the substrate 250 in order to define the windings 207A, 207B, 207C, 207D, 209, 210 will now be described. As shown in FIG. 7, each winding 207A, 207B, 207C, 207D, 209, 210 comprises upper winding traces 280 on the top region 266, lower winding traces 282 on the bottom region 262, and winding vias 284, 286 extending along the axis A through the thickness T1 of middle region 264. Each winding via 284, 286 comprises conductive plating (e.g., a via barrel) on a via opening of the substrate 250. Each upper winding trace 280 extends in a plane P1 of the top region 266 (above the CT core 205), and each lower winding trace 282 extends in a plane P2 of the bottom region 262 (below the CT core 205). The planes P1 and P2 are parallel to one another and orthogonal to the axis A1. The vias 284, 286 extend generally parallel to the axis A1 at spaced apart locations.

Each winding via 284, 286 connects one upper winding trace 280 to one lower winding trace 282. Each upper winding trace 280 extends from an upper outboard end portion outboard of the outer perimeter side 272 of the CT core 205 to an upper inboard end portion inboard of the inner perimeter side 270 of the CT core. Each lower winding trace 282 extends from a lower outboard end portion outboard of the outer perimeter side 272 of the CT core 205 to a lower inboard end portion inboard of the inner perimeter side 270 of the CT core. Outboard winding vias 284 each connect the upper outboard end portion of one upper winding trace 280 to the lower outboard end portion of one lower winding trace 282. Inboard winding vias 286 each connect the upper inboard end portion of one upper winding trace 280 to the lower inboard end portion of one lower winding trace 282. For each winding 207A, 207B, 207C, 207D, 209, 210, the upper winding traces 280, the lower winding traces 282, the outboard vias 284, and the inboard vias 286 are arranged on the PCBA substrate 250 to form a continuous winding that winds around the CT core 205 at least *n* consecutive times.

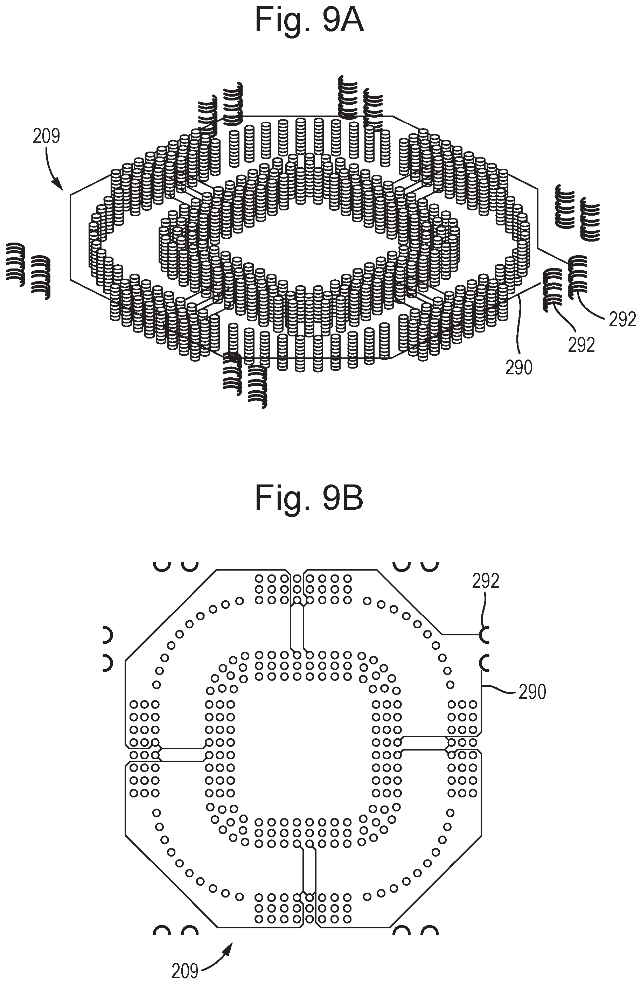

Referring to FIG. 9A-9B, an example embodiment of the layout of a set of PCBA conductors 280, 282, 284, 286 forming a test winding 209 is shown. In this example, the winding 209 winds around each side of the four-sided CT core 205 two consecutive times. Connecting traces 290 (e.g., conductive traces on the top substrate region 266 in the plane P1 and/or the bottom substrate region 262 in the plane P2) connect the windings on each of the four sides of the CT core 205 to terminal vias 292. The terminal vias 292, in turn, connect the test winding 209 to the PTT signal stimulator 219 described above.

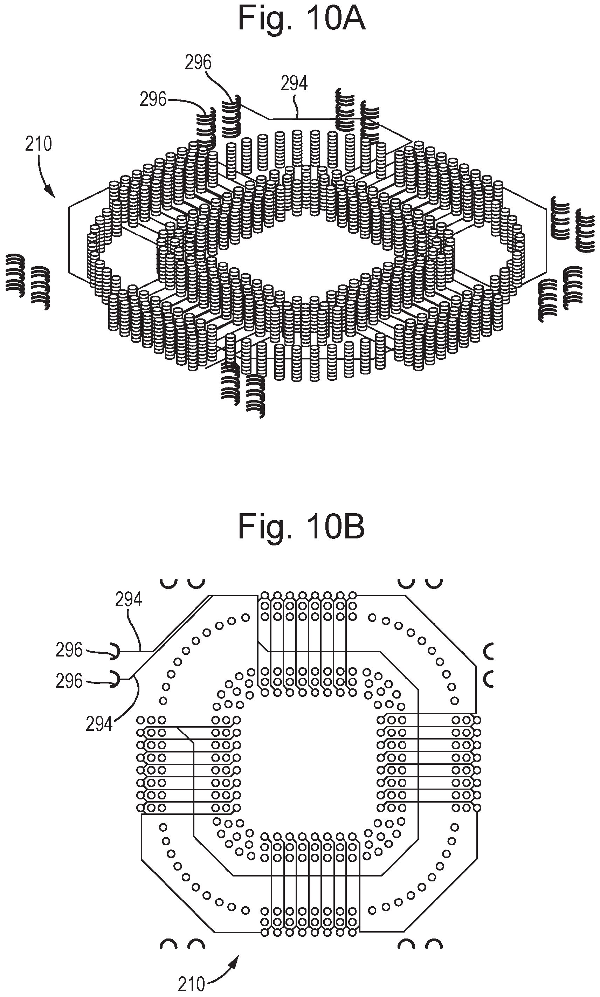

Referring to FIGS. 10A-10B, an example embodiment of the layout of a set of PCBA conductors 280, 282, 284, 286 forming a GN winding 210 is shown. In this example, the GN winding 210 winds around each side of the four-sided CT core 205 eight consecutive times. Connecting traces 294 (e.g., conductive traces on the top substrate region 266 in the plane P1 and/or the bottom substrate region 262 in the plane P2) connect the windings on each of the four sides of the core 205 to terminal vias 296. The terminal vias 296, in turn, connect the GN winding 210 to the GN stimulator 213 and GN detector 215 described above.

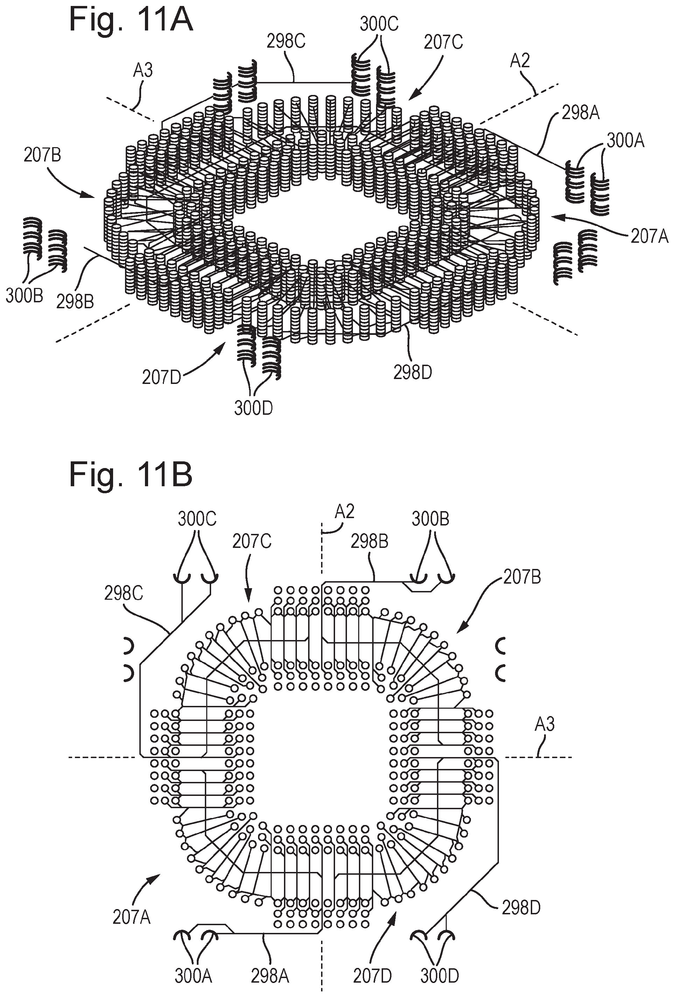

Referring to FIGS. 11A-11B, an example embodiment of the layout of a set of PCBA conductors 280, 282, 284, 286 forming sense windings 207A, 207B, 207C, 207D is shown. In this example, each sense winding 207A, 207B, 207C, 207D winds around the respective quadrant 205A, 205B, 205C, 205D of the CT core 205 (in the respective sector 203A, 203B, 203C, 203D) 18 consecutive times. Connecting traces 298A, 298B, 298C, 298D (e.g., conductive traces on the top substrate region 266 in the plane P1 and/or the bottom substrate region 262 in the plane P2) connect each sense winding 207A, 207B, 207C, 207D to a respective pair of terminal vias 300A, 300B, 300C, 300D. The terminal vias 300A, 300B, 300C, 300D, in turn, connect the sense windings 207A, 207B, 207C, 207D to the GF signal chain 217 and the GF detector 211, the AF signal chain 231 and the AF detector 233, and the current distribution signal chain 235 and the current distribution detector 237 as described above.

Accordingly, the MFPCBACSS 200 enables a multifunction differential current transformer 203 with independent windings for sensing current conditions on the primary conductors 254, 256, 258, 260 (sense windings 207A, 207B, 207C, 207D), PTT stimulation (test winding 209), and GN detection (GN winding 210) to be constructed using high-precision PCBA manufacturing techniques. This allows for very accurate control of winding pitch and distribution, which heretofore has not been achievable with a closed core CT. Furthermore, by forming conductor openings 252 directly in the PCBA substrate using high precision PCBA manufacturing processes, it is also possible to precisely control the position of the primary conductors 254, 256, 258, 260 as they pass through the closed CT core 205. Precise control over these physical parameters can directly impact the electromagnetic characteristics and sensing performance of the CT 203. Additionally, the windings 207A, 207B, 207C, 207D, 209, 210 are substantially lighter (e.g., about 70% lighter) and use substantially less raw materials (e.g., about 80% less raw materials) than conventional copper wire CT windings.

The pitch and distribution of each winding 207A, 207B, 207C, 207D, 209, 210 around the loop-shaped CT core 205 determine how uniformly it couples with the magnetic flux generated by the primary current-carrying conductors 254, 256, 258, 260 and with other windings. Precise control of the winding geometry ensures that the induced voltage in the sense windings 207A, 207B, 207C, 207D accurately reflects the differential current (for GF detection) or the specific stimulus (for PTT or GN detection). Deviations from the designed winding pitch and distribution (which can occur more frequently when conventional closed core CT manufacturing processes are used) can, by contrast, lead to variations in sensitivity, incorrect readings, or an inability to detect subtle fault conditions. The precise manufacturing control achieved using PCBA manufacturing techniques ensures that variations in winding placement or conductor paths do not lead to unit-to-unit performance discrepancies. This reduces the need for extensive individual calibration, lowers manufacturing costs, and ensures devices meet safety and operational standards consistently.

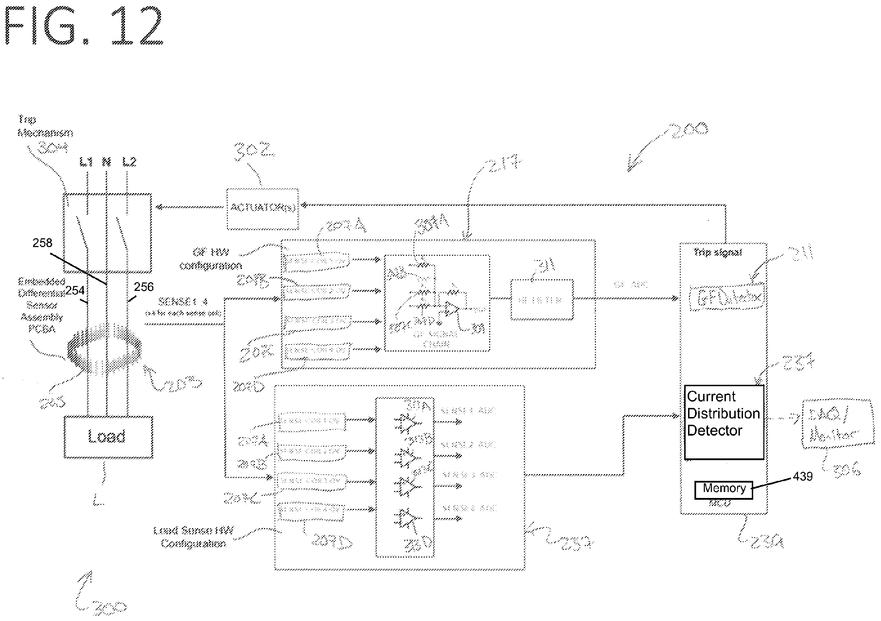

As mentioned above, providing four accurately wound, non-overlapping sense windings 207A, 207B, 207C, 207D around respective quadrants 205A, 205B, 205C, 205D of a high permeability, high saturation flux density CT core 205 enables several sophisticated primary circuit current monitoring functions to be combined in a single, low-profile CT 203. Referring to FIG. 12, an example embodiment of a multifunction circuit breaker that employs the MFPCBACSS 200 is shown schematically at reference number 300. In the illustrated example, the CT core 205 circumscribes primary conductors for 254, 256, 258 that connect a three-wire power circuit (L1, N, L2) to a load L. The circuit breaker 300 comprises one or more actuators 302 (e.g., a solenoid) connected to a trip mechanism 304 configured to selectively interrupt power to the load L (e.g., configured to be selectively actuated to interrupt current flow through the primary conductors 254, 256, 258 to a circuit that connects to the load). Those skilled in the art are familiar with the types of actuators and trip mechanisms that are used in circuit breakers, so these components will not be described further herein. As will be described in further detail below, the MCU 239 (specifically the GF detector 211 implemented on the MCU) is configured to process signals from the CT 203 that have been conditioned by the GF signal chain 217 and detect a GF condition based on the conditioned signals. In response to detecting a GF condition, the MCU 239 is configured to signal the actuator 302 to actuate the trip mechanism 304. As will be further described below, the MCU 239 (specifically the current distribution detector 237 implemented on the MCU) is configured to process signals from the CT 203 that have been conditioned by the current distribution signal chain 237 to (i) determine the load configuration, (ii) determine the location of a GF after a GF condition is detected, and (iii) measure the current carried by the primary conductors. In the illustrated embodiment, the information determined/measured by the current distribution detector 237 is output to DAQ/monitoring device 306 (or to another processor or module of the MCU 239 via onboard communication protocols), which can comprise a local indicator device (e.g., display) on the circuit breaker 300 or a remote monitoring device or system external to the circuit breaker 300. If the DAQ/monitoring device 306 comprises a remote monitoring device or system, the circuit breaker 300 can suitably comprise an antenna (not shown) for wirelessly communicating with the DAQ/monitoring device.

In general, the GF detector 211 is configured to determine a value representing a weighted sum of the induced secondary voltages in the sense windings 207A, 207B, 207C, 207D and to determine that there is a GF when the value representing the weighted sum of the secondary currents is greater than a predefined GF detection threshold. In the illustrated embodiment, the GF signal chain 217 comprises burden resistors 307A, 307B, 307C, 307D respectively connected to each of the sense windings 207A, 207B, 207C, 207D. The secondary current induced in each sense winding 207A, 207B, 207C, 207D is passed through the respective burden resistor 307A, 307B, 307C, 307D, which in turn generates a voltage proportional to the respective secondary current. The summing amplifier 309 outputs a voltage proportional to the sum of the input voltages generated by each of the coils 207A, 207B, 207C, 207D on each of the burden resistors 307A, 307B, 307C, 307D. The output voltage from the inverted summing amplifier 309 is connected to high frequency (HF) filter 311 that filters out high frequency noise from the output signal. The filtered analog voltage signal is then fed into an ADC of the GF detector 211, which produces a digital value representing the weighted sum of the induced secondary voltages in the sense windings 207A, 207B, 207C, 207D.

When there is no GF condition, the digital value representing the weighted sum of the induced secondary voltages in the sense windings 207A, 207B, 207C, 207D is substantially constant for a given load L. But when a GF occurs, there is an additional current draw on the conductor supplying current to the load L. As a result, the digital value representing the weighted sum of the induced secondary voltages in the sense windings 207A, 207B, 207C, 207D will increase when such a GF occurs. In one embodiment, the GF detector 211 is configured to detect GF conditions using basic comparator logic that detects an increase in the digital value representing the weighted sum of the induced secondary voltages in the sense windings 207A, 207B, 207C, 207D. For example, the GF detector 211 is configured to compare the digital value representing the weighted sum of the induced secondary voltages in the sense windings 207A, 207B, 207C, 207D to a predefined GF detection threshold to determine whether a GF condition is present. If the digital value representing the weighted sum of the induced secondary voltages in the sense windings 207A, 207B, 207C, 207D is greater than or equal to the predefined GF detection threshold, the GF detector 211 determines there is a ground fault and signals the actuator 302 to trip the trip mechanism. If the digital value representing the weighted sum of the induced secondary voltages in the sense windings 207A, 207B, 207C, 207D is less than the predefined GF detection threshold, no trip action is taken.

Referring still to FIG. 12, the current distribution detector 237 is connected to the sense windings 207A, 207B, 207C, 207D and is broadly configured to determine a value for each sense winding representing the secondary current induced in the sense winding. In this way, the current distribution detector 237 detects the distribution of induced secondary currents between the four quadrants 205A, 205B, 205C, 205D of the CT core and can use that information to (i) determine a GF location, (ii) determine a load configuration, and/or (iii) measure the current carried by the primary conductors 254, 256, 258, 260. The current distribution signal chain 237 comprises a dedicated operational amplifier 313A, 313B, 313C, 313D for each sense winding 207A, 207B, 207C, 207D. Each operational amplifier 313A, 313B, 313C, 313D is configured to connect the output of each sense winding to a respective ADC of the current distribution detector 237. Thus, each ADC of the current distribution detector 237 is configured to generate a digital signal representing the secondary current induced in a respective one of the sense windings 207A, 207B, 207C, 207D. Based on the digital signals representing the secondary current induced in each of the sense windings 207A, 207B, 207C, 207D, the current distribution detector 237 is configured to determine the load configuration, determine the GF location when the GF detector 211 detects a GF condition, and measure the load current.

For purposes of load current measurement, the output voltage from each sense winding 207A, 207B, 207C, 207D (after the induced secondary current passes through the respective burden resistor) is proportional to the load current. Thus, in one or more embodiments, the current distribution detector 237 is configured to measure load current as a function of the digital signals from one or more of the ADCs that individually connected to the sense windings 207A, 207B, 207C, 207D via the operational amplifiers 313A, 313B, 313C, 313D. In certain embodiments, the current distribution detector 237 is configured to output the measured load current to the DAQ/monitoring device 306.

In general, the current distribution detector 237 is configured to determine load configuration by analyzing the digital signals representing the secondary current induced in each of the sense windings 207A, 207B, 207C, 207D to identify characteristic magnetic flux patterns based on the secondary currents induced along each of the four quadrants 205A, 205B, 205C, 205D of the CT core 205. As will be shown in Examples 1-4 below, each load configuration generates a different magnetic flux pattern in the CT core 205, which induces corresponding secondary currents in the four sense windings 207A, 207B, 207C, 207D. Because the CT 203 is constructed using the high-precision PCBA manufacturing techniques discussed above, the winding pitch and distribution of the four sense windings 207A, 207B, 207C, 207D and the placement of each of the four primary current conductors 254, 256, 258, 260 in relation to the sense windings is essentially the same for every MFPCBACSS 200. As a result, the effect each load configuration on the secondary currents induced in the four sense windings 207A, 207B, 207C, 207D can be simulated or determined empirically in advance and stored as predetermined model load configuration values in memory 439 (e.g., tangible machine-readable memory) accessible to the current distribution detector 237. Thus, in one or more embodiments, the current distribution detector 237 is configured to determine the load configuration by comparing the digital signals representing the secondary current induced in each of the sense windings 207A, 207B, 207C, 207D to the predetermined model load configuration values to determine closest fit. That is, the current distribution detector 237 is configured to compare the values representing the secondary current induced in each sense winding 207A, 207B, 207B, 207C with predetermined model load configuration values for each of a plurality of possible load conditions to determine closest fit. In certain embodiments, the current distribution detector 237 is configured to output the determined load configuration to the DAQ/monitoring device 306.

To demonstrate the feasibility of determining the load configuration based on the secondary currents induced in the individual sense windings 207A, 207B, 207C, 207D along each quadrant 205A, 205B, 205C, 205D of the closed CT core 205, several magnetic flux patterns generated by several different load configurations will now be provided by way of example.

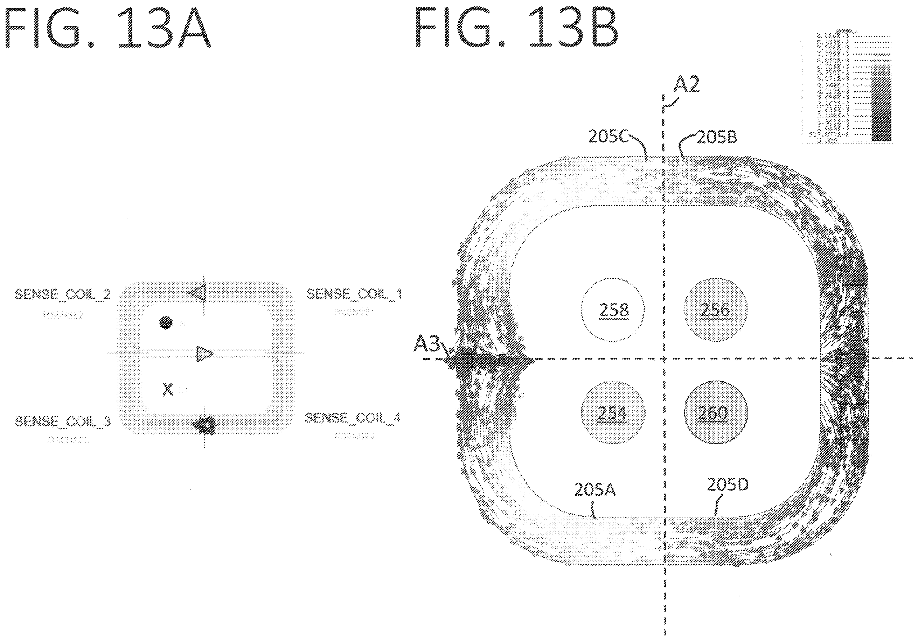

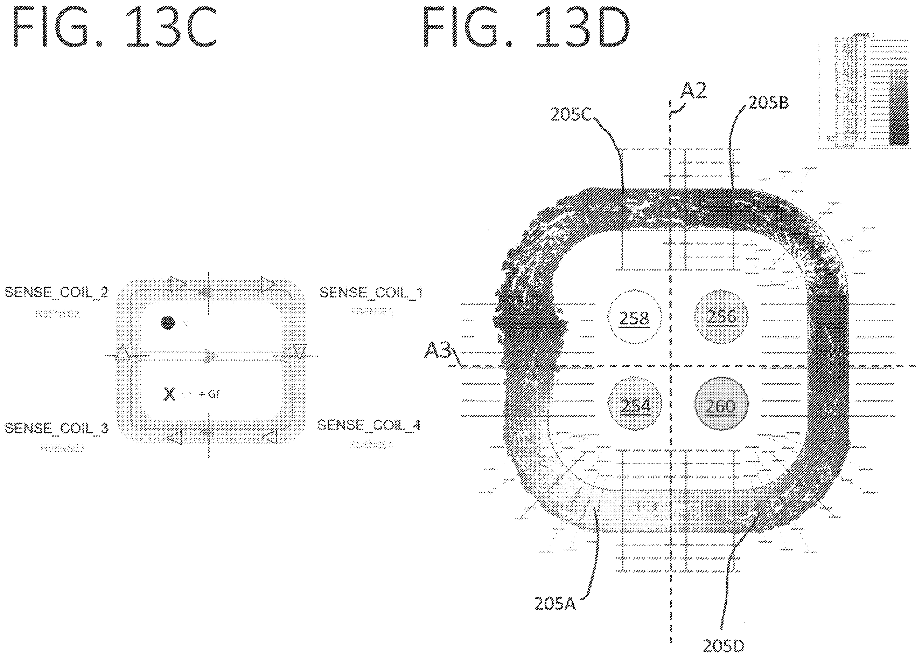

**Example 1 - L1-N:** FIGS. 13A-13B depict the magnetic flux characteristics within the closed CT core 205 in a first (L1-N) load configuration when power is supplied to the load L via the first primary line conductor 254 and returned via the primary neutral conductor 258. As depicted, this load configuration generates a characteristic magnetic flux within the core 205. Specifically, a predominantly counterclockwise flux is generated in the quadrants 250B, 250C, and a predominantly clockwise flux is generated in the opposite quadrants 205A, 205D. The flux density is greatest in quadrant 205C and quadrant 205A (nearest the primary conductors 254, 258 that carry the current), and much less in quadrants 205B and 205D. Consequently, the respective sense windings 207A, 207B, 207C, 207D that are individually disposed on these quadrants 205A, 205B, 205C, 205D produce output signals that are responsive to these specific magnetic flux conditions. When these output signals, under this L1-N configuration, are compared with the predetermined model load configuration values for each load configuration possibility, the current distribution detector 237 will determine the L1-N load configuration as the closest fit and output a signal to the DAQ/monitoring device 306 indicating that the L1-N load condition has been detected.

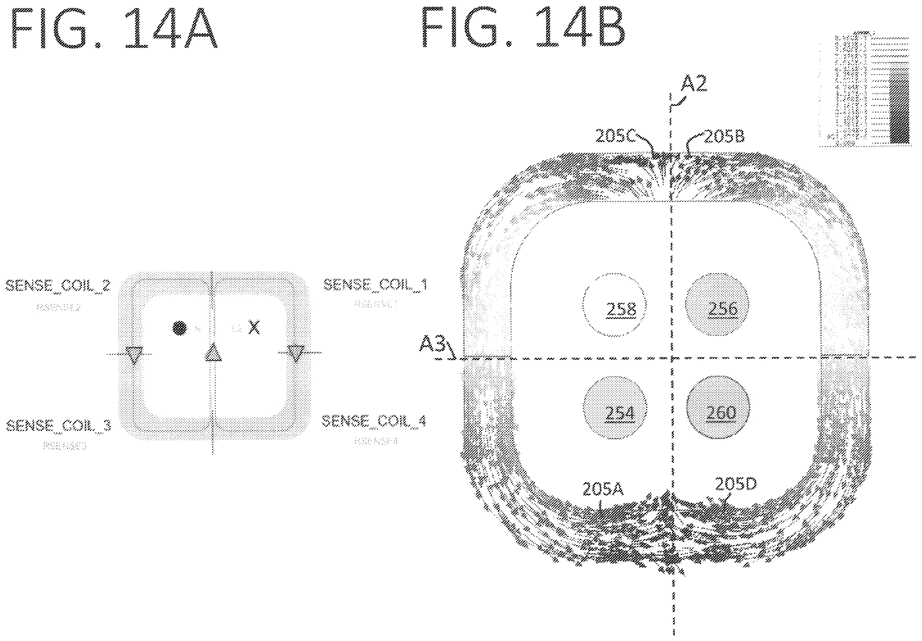

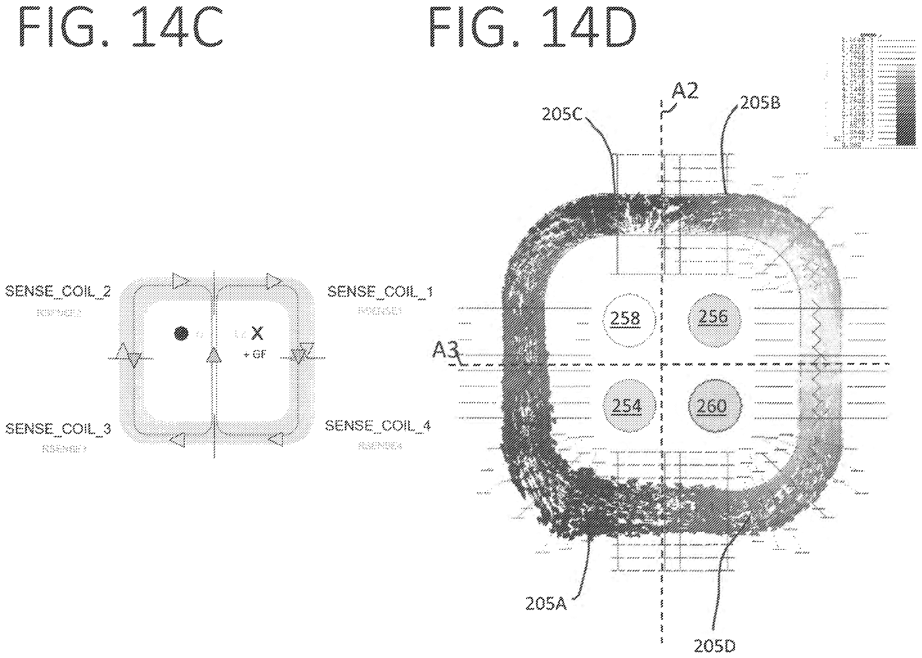

**Example 2 - L2-N:** FIGS. 14A-14B depict the magnetic flux characteristics within the closed CT core 205 in a second (L2-N) load configuration when power is supplied to the load L via the second primary line conductor 256 and returned via the primary neutral conductor 258. As depicted, this load configuration generates a characteristic magnetic flux within the core 205. Specifically, a predominantly counterclockwise flux is generated in the quadrants 250C, 250A, and a predominantly clockwise flux is generated in the opposite quadrants 205B, 205D. The flux density is greatest in quadrant 205C and quadrant 205B (nearest the primary conductors 256, 258 that carry the current), and notably less in quadrants 205A and 205D. Consequently, the respective sense windings 207A, 207B, 207C, 207D that are individually disposed on these quadrants 205A, 205V, 205C, 205D produce output signals that are responsive to these specific magnetic flux conditions. When these output signals, under this L2-N configuration, are compared with the predetermined model load configuration values for each load configuration possibility, the current distribution detector 237 will determine the L2-N load configuration as the closest fit and output a signal to the DAQ/monitoring device 306 indicating that the L2-N load condition has been detected.

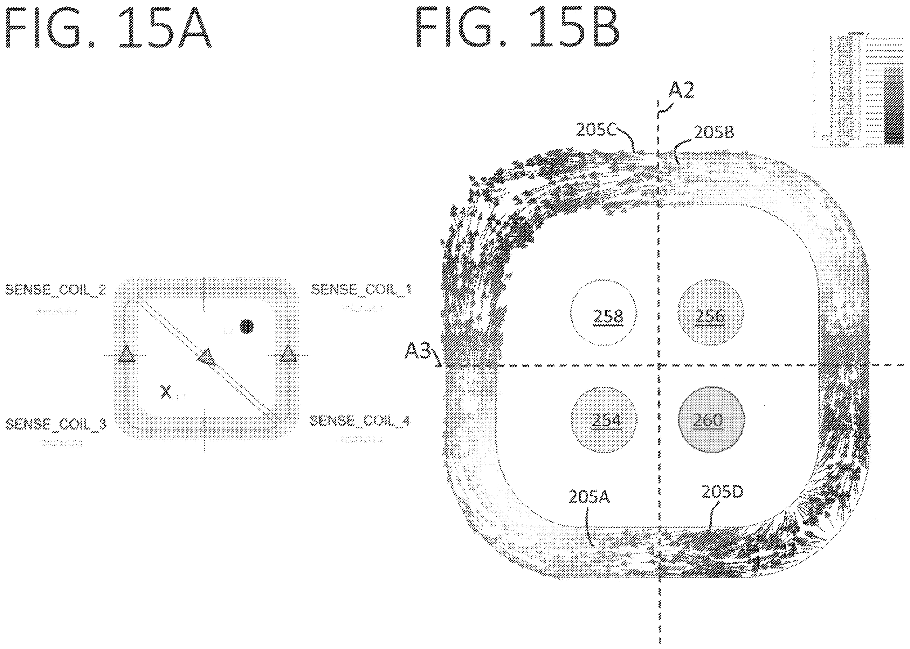

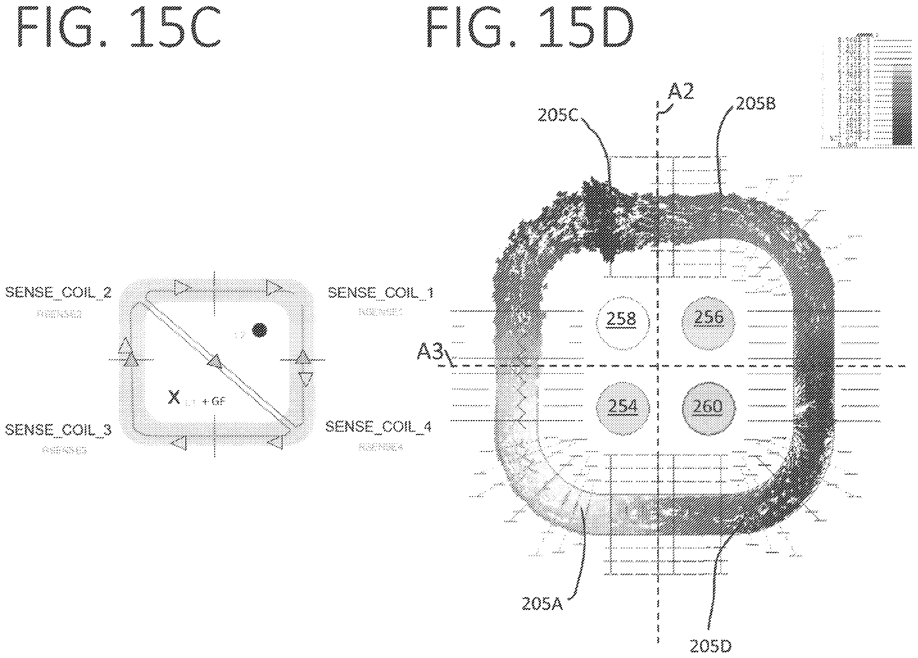

**Example 3 - L1-L2:** FIGS. 15A-15B depict the magnetic flux characteristics within the closed CT core 205 in a third (L1-L2) load configuration when power is supplied to the load L via a first primary line conductor 254 and returned via the second primary line conductor 256. As depicted, this load configuration generates a characteristic magnetic flux within the core 205. Specifically, a predominantly counterclockwise flux is generated in the quadrant 205B, and a predominantly clockwise flux is generated in the quadrant 205A. The flux in quadrant 205C thus converges at about the circumferential midpoint, whereas the flux in quadrant 205D diverges at about the circumferential midpoint. The flux density is greatest in quadrant 205A and quadrant 205B (nearest the primary conductors 254, 256 that carry the current), and notably less in quadrants 205C and 205D. Consequently, the respective sense windings 207A, 207B, 207C, 207D that are individually disposed on these quadrants 205A, 205B, 205C, 205D produce output signals that are responsive to these specific magnetic flux conditions. When these output signals, under this L1-L2 load configuration, are compared with the predetermined model load configuration values for each load configuration possibility, the current distribution detector 237 will determine the L1-L2 load configuration as the closest fit and output a signal to the DAQ/monitoring device 306 indicating that the L1-L2 load condition has been detected.

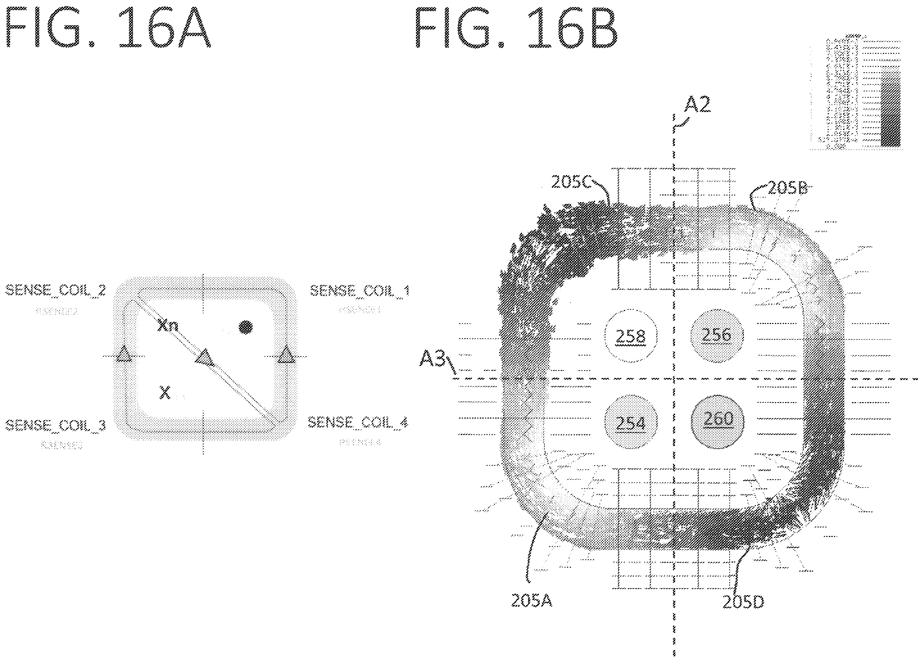

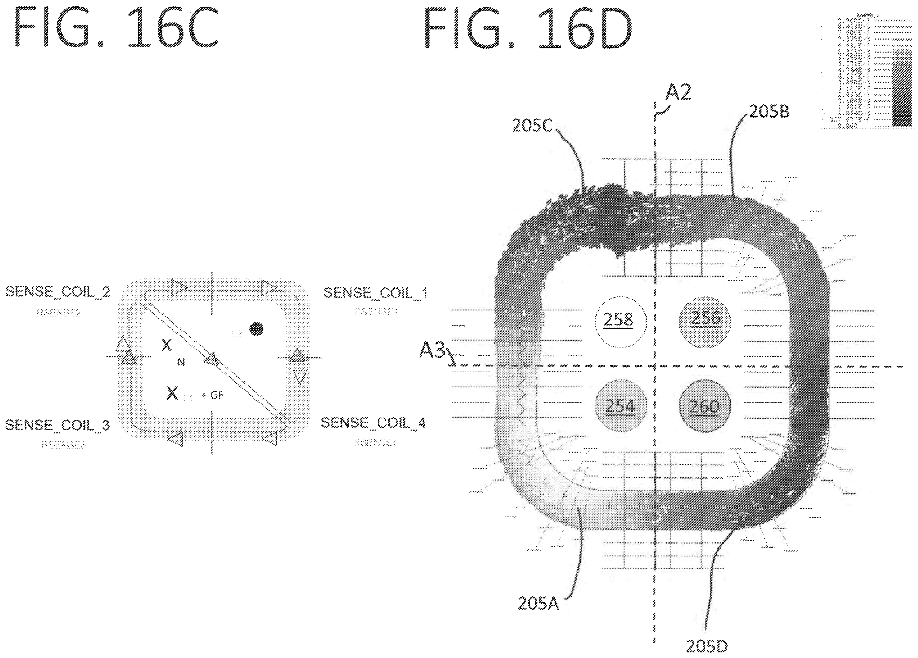

**Example 4 - L1-N-L2:** FIGS. 16A-16B depict the magnetic flux characteristics within the closed CT core 205 in a fourth (L1-N-L2) load configuration when power is supplied to the load L via a first primary line conductor 254 and returned via the second primary line conductor 256 and the primary neutral conductor 258. As depicted, this load configuration generates a characteristic magnetic flux within the core 205. Specifically, a predominantly counterclockwise flux is generated in the quadrant 205B, and a predominantly clockwise flux is generated in the quadrant 205A. The flux in quadrant 205C thus converges at about the circumferential midpoint, whereas the flux in quadrant 205D diverges at about the circumferential midpoint. The flux density is greatest in quadrant 205A and quadrant 205B (nearest the primary conductors 254, 256 that carry the current), and the flux density in quadrant 205C is notably greater than in quadrant 205D (while still being less than quadrants 205A and 205B). This creates a sensible shift in the flux distribution when compared to the flux distribution in the L1-L2 load configuration from Example 3. Consequently, the respective sense windings 207A, 207B, 207C, 207D that are individually disposed on these quadrants 205A, 205B, 205C, 205D produce output signals that are responsive to these specific magnetic flux conditions. When these output signals, under this L1-N-L2 load configuration, are compared with the predetermined model load configuration values for each load configuration possibility, the current distribution detector 237 will determine the L1-N-L2 load configuration as the closest fit and output a signal to the DAQ/monitoring device 306 indicating that the L1-N-L2 load condition has been detected.

Referring again to FIG. 12, the current distribution detector 237 is further configured to determine the GF location after the GF detector 211 detects a GF condition. In general, the current distribution detector 237 is configured to determine the GF location by determining which of the values representing the secondary current induced in each sense winding 207A, 207B, 207C, 207D is greatest. When a GF condition occurs on the line (or supply) conductor in an electrical circuit, it creates an unintended alternative path for current to flow directly to ground. Normally, when there is no GF, the current flowing from the source through the line conductor to the load is equal to the current returning from the load through the neutral (or return) conductor. With a GF on the line conductor, the total current drawn from the source through the line conductor includes both the current consumed by the load and the additional current flowing through this new fault path to ground. Since only the current that passed through the intended load returns on the neutral conductor, an imbalance is created where the line conductor carries more current than the neutral conductor.

Using the multifunction CT 203 of the present disclosure, the location of the ground fault is detectable because the increased current flow on the conductor 254, 256, 258, 260 with the GF will generate increased magnetic flux in the quadrant 205A, 205B, 205C, 205D of the CT core 205 located nearest to the primary conductor with the ground fault, which in turn induces a greater secondary current in the sense winding 207A, 207B, 207C, 207D as compared with the other sense windings, which manifests at the current distribution detector 237 as the digital signal representing the secondary current induced in the sense winding nearest the primary conductor 254, 256, 258, 260 being greater than the digital signals representing the secondary currents induced in the other sense windings. Accordingly, in one or more embodiments, after the GF detector 211 detects a GF condition, the current distribution detector 237 is configured to determine the location of the ground fault by comparing the digital signals representing the secondary current induced in each of the sense windings 207A, 207B, 207C, 207D to determine the signal with the greatest magnitude. The current distribution detector 237 then determines that the GF is located in the primary conductor 254, 256, 258, 260 nearest the sense winding 207A, 207B, 207C, 207D that produced the digital signal with the greatest magnitude. In certain embodiments, the current distribution detector 237 is configured to output the determined GF location to the DAQ/monitoring device 306.

To demonstrate the feasibility of determining the GF location based on the secondary currents induced in the individual sense windings 207A, 207B, 207C, 207D along each quadrant 205A, 205B, 205C, 205D of the closed CT core 205, several magnetic flux patterns generated by GFs at several different primary conductor locations will now be provided by way of example.

**Example 5 - L1+GF-N:** FIGS. 13C-13D show the magnetic flux characteristics when power is supplied to the load L via a first primary line conductor 254 and returned via the primary neutral conductor 258 but there is a GF on the first primary line conductor. In contrast with the non-GF L1-N load configuration depicted in FIGS. 13A-13B, the magnetic flux in this GF scenario concentrates in the quadrant 205A that is located nearest to the first primary line conductor 254 that has the GF. Hence, after the GF detector 211 detects that a GF has occurred (using the logic described above), the current distribution detector 237 will determine that the GF is located on the first primary line conductor 254 because the magnitude of the digital signal representing the current induced in the sensing winding 207A disposed on the quadrant 205A will be greater than the magnitudes of the digital signals representing the currents induced in the other sense windings 207B, 207C, 207D.

**Example 6 - L2+GF-N:** FIGS. 14C-14D show the magnetic flux characteristics when power is supplied to the load L via the second primary line conductor 256 and returned via the primary neutral conductor 258 but there is a GF on the second primary line conductor. In contrast with the non-GF L2-N load configuration depicted in FIGS. 14A-14B, the magnetic flux in this GF scenario concentrates in the quadrant 205B that is located nearest to the second primary line conductor 256 that has the GF. Hence, after the GF detector 211 detects that a GF has occurred (using the logic described above), the current distribution detector 237 will determine that the GF is located on the second primary line conductor 256 because the magnitude of the digital signal representing the current induced in the sensing winding 207B disposed on the quadrant 205B will be greater than the magnitudes of the digital signals representing the currents induced in the other sense windings 207A, 207C, 207D.

**Example 7 - L1+GF-L2:** FIGS. 15C-15D show the magnetic flux characteristics when power is supplied to the load L via the first primary line conductor 254 and returned via the second primary line conductor 256 but there is a GF on the first primary line conductor. In contrast with the non-GF L1-L2 load configuration depicted in FIGS. 15A-15B, the magnetic flux in this GF scenario concentrates in the quadrant 205A that is located nearest to the first primary line conductor 254 that has the GF. Hence, after the GF detector 211 detects that a GF has occurred (using the logic described above), the current distribution detector 237 will determine that the GF is located on the first primary line conductor 254 because the magnitude of the digital signal representing the current induced in the sensing winding 207A disposed on the quadrant 205B will be greater than the magnitudes of the digital signals representing the currents induced in the other sense windings 207B, 207C, 207D.

**Example 8 - L1+GF-N-L2:** FIGS. 16C-16D show the magnetic flux characteristics when power is supplied to the load L via the first primary line conductor 254 and the neutral conductor 258 and returned via the second primary line conductor 256 but there is a GF on the first primary line conductor. In contrast with the non-GF L1-N-L2 load configuration depicted in FIGS. 16A-16B, the magnetic flux in this GF scenario concentrates in the quadrant 205A that is located nearest to the first primary line conductor 254 that has the GF. Hence, after the GF detector 211 detects that a GF has occurred (using the logic described above), the current distribution detector 237 will determine that the GF is located on the first primary line conductor 254 because the magnitude of the digital signal representing the current induced in the sensing winding 207A disposed on the quadrant 205B will be greater than the magnitudes of the digital signals representing the currents induced in the other sense windings 207B, 207C, 207D.

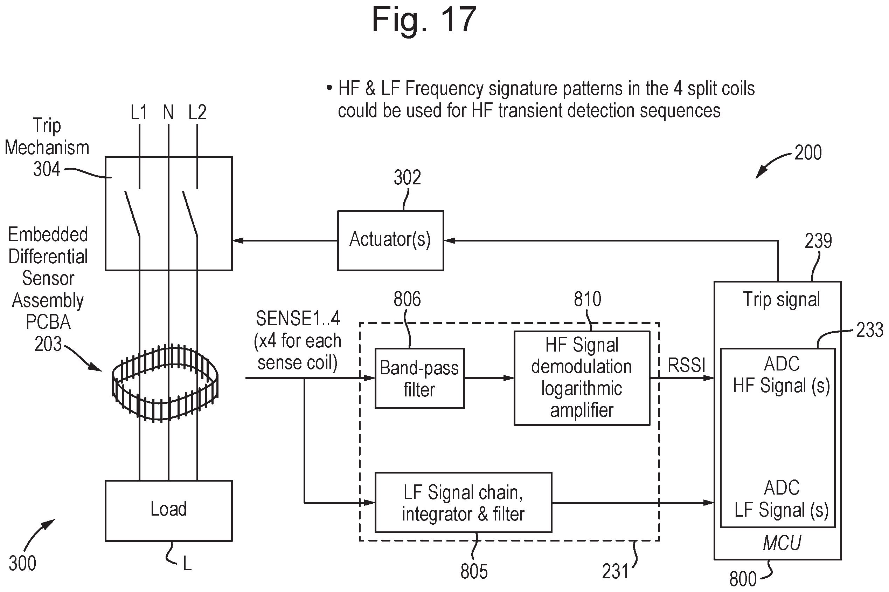

Referring now to FIG. 17, an embodiment of the circuit breaker 300 configured to use the CT 203 for AF detection will now be described. Those skilled in the art will understand that conventional closed core CTs have limitations in detecting faint, high-frequency arc fault signatures because their ferromagnetic cores can be driven into saturation by the strong, low-frequency AC power. Furthermore, the magnetic properties and construction of conventional closed cores typically result in a restricted high-frequency bandwidth, which attenuates or distorts the arc's characteristic signals. Air-core Rogowski sensors, conversely, are immune to magnetic saturation and do not suffer from core-related high-frequency losses due to their air-core design, enabling a more accurate response to the rapid current changes (high *di*/*dt*) and broadband HF signal content of arc faults. Hence air-core Rogowski sensors are typically used for arc fault detection. Surprisingly, the inventors have discovered that the CT 203, with its four PCBA windings 207A, 207B, 207B, 207D around non-overlapping quadrants 205A, 205B, 205C, 205D of the nanocrystalline core 205, behaves more like a Rogowski sensor at high frequencies, while still behaving like a conventional closed core CT at low frequencies. Accordingly, it is thought to be possible to use the CT 203 for AF detection by using the AF signal chain 231 to select for broadband high frequency (HF) signal content and using the AF detector 233 to detect an arc fault signature in the broadband HF signal content.

The AF signal chain 231 is configured to individually condition the signals output from each of the sense windings 207A, 207B, 207C, 207D along parallel signal chains with the same functionality. In FIG. 17 only one representative signal chain 231 is shown for clarity. Each signal chain 231 includes a HF path and low frequency (LF) path. On the HF path, the signal output from each sense winding 207A, 207B, 207C, 207D is provided to a band-pass filter 806 that selects the broadband HF signal content for demodulation and amplification by an HF signal demodulation log amp 810. The log amp 810 outputs a received signal strength indicator (RSSI) voltage indicating the strength of the broadband HF signal content from the respective sense winding 207A, 207B, 207C, 207D. The AF detector 233 comprises an ADC 812 configured to convert the RSSI voltage to an HF digital signal. Along the LF path, an integrator and filter 805 condition the signal output from each sense winding 207A, 207B, 207C, 207D before the conditioned signal is converted to an LF digital signal by an LF ADC of the AF detector 233. By analyzing the HF digital signal and the LF digital signal, the AF detector 233 is configured to detect AF signatures (e.g., signature broadband HF signal content in the secondary current induced in one or more of the sense windings 207A, 207B, 207C, 207D).

Accordingly, the present disclosure provides an MFPCBACSS 200 that is suitable for use with various types of protective circuit breakers. By using PCBA fabrication techniques to accurately form a plurality of discrete, non-overlapping sense windings on different segments of a closed ferromagnetic core and precisely routing primary circuit conductors through the closed core at predetermined locations, it is possible to obtain a more robust and reliable indication of the flux generated in the CT core. This enables a single, small-form-factor CT to provide multifunction circuit analysis, including, GF detection, GF location detection, current measurement, load configuration determination, AF detection, push-to-test operations, and/or GN detection.

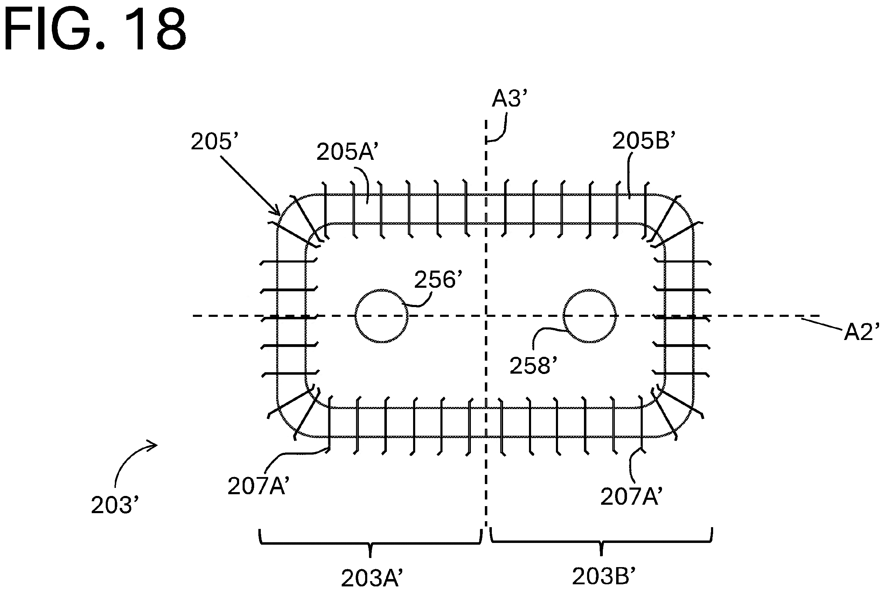

Those skilled in the art will recognize that the general concept of - providing a plurality of discrete, non-overlapping sense windings on different segments of a closed ferromagnetic core and precisely routing primary circuit conductors through the core at predetermined locations - has many potential application beyond the specific example shown in the drawings. As another example, referring to FIG. 18, in one embodiment a CT 203' comprises a (rectangular) loop-shaped CT core 205' with two primary conductors 256' 258' (e.g., one line conductor and one neutral conductor) routed through the CT core at symmetrical positions in relation to the axes A2', A3' of the CT core. The CT 203' has two angular sectors 203A', 203B' on opposite sides of the axis A2', and thus the CT core 205' has non-overlapping halves 205A', 205B' in the respective angular sectors 203A'. 203B'. The CT 203' comprises a first winding 207A' wound around the first half 205A' of the CT core and a second winding 207B' wound around the second half 205B'. The windings 207A', 207B' are non-overlapping, and each is relatively more sensitive to current flowing on the primary conductor 256', 258' nearest to it. Suitably, the CT 203' is formed as a PCBA in the same manner as the CT 203 described above. This is just one alternative configuration for a CT in accordance with the present disclosure. Other alternative CT configurations can be used without departing from the scope of the disclosure.

When introducing elements of the present disclosure or the preferred embodiment(s) thereof, the articles "a", "an", "the" and "said" are intended to mean that there are one or more of the elements. The terms "comprising", "including" and "having" are intended to be inclusive and mean that there may be additional elements other than the listed elements.

In view of the above, it will be seen that the several objects of the disclosure are achieved and other advantageous results attained.

As various changes could be made in the above products and methods without departing from the scope of the disclosure, it is intended that all matter contained in the above description shall be interpreted as illustrative and not in a limiting sense.

## Claims

1. A multifunction printed circuit board assembly current sensor system (MFPCBACSS) for use in a circuit breaker, the MFPCBACSS comprising:
a printed circuit board assembly (PCBA) comprising:
a PCBA substrate; and
a current transformer (CT) in the PCBA substrate, the CT having a plurality of sectors and comprising:
a CT core; and
PCBA conductors arranged on the PCBA substrate to define a plurality of non-overlapping sense windings around the CT core, the sense windings including one respective sense winding in each sector of the CT; and
a plurality of primary conductors extending through the CT core to interact magnetically with the CT core such that current carried by the primary conductors generates magnetic flux in the CT core and the magnetic flux generated in each sector of the CT induces a secondary current in the respective sense winding.

2. The MFPCBACSS of claim 1, further comprising a ground fault (GF) detector and a current distribution detector connected to the sense windings.

3. The MFPCBACSS of claim 2, further comprising an arc fault (AF) detector connected to the sense windings.

4. The MFPCBACSS of claim 1, further comprising a GF detector configured to determine a value representing a weighted sum of the induced secondary voltages in the sense windings and to determine there is a GF when the value representing the weighted sum of the induced secondary voltages is greater than a predefined GF detection threshold.

5. The MFPCBACSS of claim 1, further comprising a current distribution detector connected to the sense windings and configured to determine a value for each sense winding representing the secondary current induced in the sense winding.

6. The MFPCBACSS of claim 5, wherein the current distribution detector is configured to (i) determine a GF location, (ii) determine a load configuration, and/or (iii) measure the current carried by the primary conductors based on the values representing the secondary current induced in each sense winding.

7. The MFPCBACSS of claim 6, wherein the current distribution detector is configured to determine the load configuration by identifying a characteristic magnetic flux pattern based on the values representing the secondary current induced in each sense winding.

8. The MFPCBACSS of claim 7, wherein the current distribution detector is configured to compare the values representing the secondary current induced in each sense winding with predetermined model load configuration values for each of a plurality of possible load conditions to determine closest fit.

9. The MFPCBACSS of claim 6, wherein the current distribution detector is configured to determine the GF location by determining which of the values representing the secondary current induced in each sense winding is greatest.

10. The MFPCBACSS of claim 1, further comprising an AF detector connected to the sense windings and configured to detect an AF by detecting signature broadband high frequency content in the secondary current induced in one or more of the sense windings.

11. The MFPCBACSS of claim 1, wherein the plurality of sectors is four sectors and the CT core comprises one quadrant in each sector.

12. The MFPCBACSS of claim 11, wherein the PCBA substrate defines one conductor opening in each sector and wherein the plurality of primary conductors comprises one primary conductor around each quadrant.

13. The MFPCBACSS of claim 1, wherein the CT core comprises nanocrystalline material.

14. The MFPCBACSS of claim 1, wherein the PCBA further comprises additional PCBA conductors in the PCBA substrate defining a test winding and a grounded neutral (GN) winding.

15. The MFPCBACSS of claim 1, wherein the PCBA conductors arranged on the PCBA substrate to define the sense windings comprise upper conductive traces above the CT core, lower conductive traces below the CT core, inboard vias on an inboard side of the CT core and outboard vias on an outboard side of the CT core.

16. A current transformer (CT) for a circuit breaker, the CT having first, second, third, and fourth sectors, the CT comprising:
a CT core having a first quadrant in the first sector of the CT, a second quadrant in the second sector of the CT, a third quadrant in the third sector of the CT, and a fourth quadrant in the fourth sector of the CT;
a first sense winding around the first quadrant of the CT core, a second sense winding around the second quadrant of the CT core, a third sense winding around the third quadrant of the CT core, and a fourth sense winding around the fourth quadrant of the CT core, wherein the first sense winding, the second sense winding, the third sense winding, and the fourth sense winding are non-overlapping; and
a first primary conductor extending through the CT core in the first sector of the CT, a second primary conductor extending through the CT core in the second sector of the CT, and a third primary conductor extending through the CT core in the third sector of the CT.

17. The CT of claim 16, further comprising a fourth primary conductor extending through the CT core in the fourth sector of the CT.

18. The CT of claim 16, further comprising a test winding around the CT core and a grounded neutral (GN) winding around the CT core.

19. A circuit breaker comprising:
a current transformer having a plurality of sectors and comprising a single current transformer (CT) core and a plurality of non-overlapping sense windings, each sense winding disposed around a respective one of the sectors of the CT core;
a plurality of primary conductors extending through the CT core to interact magnetically with the CT core such that current carried by the primary conductors generates magnetic flux in the CT core and the magnetic flux generated in each sector of the CT core induces a secondary current in the respective sense winding;
a trip mechanism configured to be selectively actuated to interrupt current flow through the primary conductors to a circuit;
an actuator configured to selectively actuate the trip mechanism;
a ground fault detector configured to detect a ground fault in the circuit based on the secondary currents induced in the plurality of sense windings and to signal the actuator to actuate the trip mechanism in response to detecting the ground fault; and
an arc fault detector configured to detect an arc fault in the circuit based on the secondary currents induced in the plurality of sense windings and to signal the actuator to actuate the trip mechanism in response to detecting the arc fault.

20. The circuit breaker of claim 19, further comprising a current distribution detector configured to determine, based on the secondary currents induced in the plurality of sense windings, (i) a ground fault location, (ii) a load configuration, and/or (iii) an amount of current carried by the primary conductors.
